# EUROPÄISCHE PATENTSCHRIFT

(11) **EP 2 169 831 B1**
(45) Veröffentlichungstag und Bekanntmachung des Hinweises auf die Patenterteilung: **19.06.2013**
(21) Anmeldenummer: 09166537.2
(22) Anmeldetag: 28.07.2009
(51) Int. Cl.: H03M 1/10, H03M 1/12

(54) **Verfahren und Korrekturvorrichtung zur Korrektur eines Offsetfehlers eines Signalwandlers**
Method and correction device for correcting an offset error of a signal converter
Procédé et dispositif de correction pour la correction d'une erreur offset d'un convertisseur de signal

(30) Priorität: 26.09.2008 DE 102008042400
(43) Veröffentlichungstag der Anmeldung: 31.03.2010
(73) Patentinhaber: Robert Bosch GmbH, 70442 Stuttgart (DE)
(72) Erfinder: Karner, Ruediger, 70806 Kornwestheim (DE); Oechtering, Peter, 76229 Karlsruhe (DE)

(56) Entgegenhaltungen:
- WO-A1-92/04775
- US-A- 5 610 810
- US-B1- 6 433 713
- KORNBLUM J: 'TB329. Technical Brief. Intersil Sigma-Delta Calibration Technique.', [Online] Mai 1995, Gefunden im Internet: <URL:http://www.intersil.com/data/tb/tb329. pdf> [gefunden am 2012-02-06]

## Beschreibung

Die vorliegende Erfindung betrifft ein Verfahren zur Korrektur eines Offsetfehlers eines Signalwandlers gemäß Anspruch 1 sowie eine Korrekturvorrichtung zur Korrektur eines Offsetfehlers eines Signalwandlers gemäß Anspruch 9.

In aktuellen Applikationen werden Offsetfehler bei Analog-Digital-Wandlerschaltungen (AD-Wandler) in den Gesamtfehler mit einberechnet und damit ausgewiesen. In manchen Systemen, in denen eine höhere Genauigkeit gefordert ist, wird eine Offsetspannungsmessung durchgeführt und der dort gemessene Betrag mit Hilfe der Software mit dem späteren Messwert verrechnet.

Im Moment gibt es die Möglichkeit eine Offsetkompensation über eine Software anzusteuern. Diese Methode hat aber den Nachteil, dass die Software die Offsetfehlermessung implizit aktivieren, das Messergebnis speichern und mit jedem gemessenen Wert verrechnen muss. Dies erfordert einen Mehraufwand in der Kommunikation sowie in der Datenberechnung was in zeitkritischen Systemen zu Problemen mit der Programmlaufzeit führen kann.

In der US 5,610,810 wird ein Ansatz vorgeschlagen, eine Anpassung der Verstärkung und eines Offsets eines Datenverarbeitungsgeräts zur Steuerung des Betriebs eines Kopierers oder dergleichen auf einmal durchzuführen, ohne dass die Anpassung der einzelnen Komponenten erforderlich wird, aus denen sich das Gerät (wie beispielsweise einem A/D-Wandler) zusammensetzt. Änderungen der Verstärkung und/oder des Offsets des Gerätes, die mit der Zeit auftreten, können kompensiert werden. Ein Datenabruf und eine Datenausgabe können hierbei durchgeführt werden.

Die WO 92/04775 A1 offenbart eine verbesserte selbstnullende Vorrichtung und ein Verfahren für ein computergestütztes tomographisches Daten-Erfassungssystem.

Die US 6,433713 B offenbart eine Kalibrierung eines Analog-Digital-Wandlers.

Die Druckschrift Komblum J, "TB329. Technical Brief: Intersil Sigma-Delta Calibration Technique.", Mai 1995 zeigt eine Vorgehensweise zur Kalibrierung eines Sigma-Delta-Wandlers von Intersil.

Die vorliegende Erfindung schafft ein Verfahren zur Korrektur eines Offsetfehlers eines Signalwandlers, wobei das Verfahren die im Anspruch 1 definierten Schritte aufweist.

Ferner schafft die vorliegende Erfindung eine Korrekturvorrichtung zur Korrektur eines Offsetfehlers eines Signalwandlers, wobei die Korrekturvorrichtung die im Anspruch 9 definierten Merkmale umfasst:

Die vorliegende Erfindung basiert auf der Erkenntnis, dass eine schnelle Korrektur von Offsetfehlern eines Signalwandlers dadurch erfolgen kann, dass in einer Recheneinheit ein von dem Signalwandler ausgegebener Messwert für eine elektrische Größe (die beispielsweise eine Spannung oder ein Strom sein kann) mit einem in dieser Recheneinheit gespeicherten Offsetwert verknüpft werden kann, wobei eine Verknüpfungsstruktur in Hardware verwendet wird. Speziell im Falle der Verwendung von Analog-Digital-Wandlern als Signalwandler ist eine solche Offsetfehlerkompensation besonders günstig. Der Offsetwert kann dabei zuvor in einem Trainingsdurchgang ermittelt werden, indem zunächst ein spezieller Offsetkanal, der einen Referenzstrom oder eine Referenzspannung bereitstellt, an den Eingang des Signalwandlers angeschlossen wird und anschließend ein von den Signalwandler ausgegebener Wert vom Ausgang des Signalwandlers erfasst und als Offsetwert in einem Speicher der Recheneinheit abgelegt wird.

Der Vorteil des erfindungsgemäßen Ansatzes besteht darin, dass die Offsetfehlerkorrektur vor Ausgabe des korrigierten Messwertes beispielsweise an einen Datenbus in einer einzigen Hardwarestruktur erfolgt. Diese Hardwarestruktur kann beispielswiese ein Mikrocontroller, ein Mikroprozessor, ein digitaler Signalprozessor, ein anwendungsspezifischer integrierter Schaltkreis oder ein ähnliches Element der elektronischen Datenverarbeitung sein. Auf diese Weise lässt sich die Offsetfehlerkorrektur auf der Basis einer Software-induzierten Abfrage des Offsetfehlers am Signalwandler vermeiden, welche in zeitkritischen Anwendungen durch die numerisch aufwändige Abarbeitung von Programmbefehlen zu langsam ist. Zugleich kann vermieden werden, dass bei der Herstellung einer entsprechenden Schaltung ein vorbestimmter Offsetfehler eines Signalwandlers in der Recheneinheit fest einprogrammiert wird. Eine solche feste Einprogrammierung eines vorbestimmten Offsetfehlers hätte den Nachteil, dass beispielsweise alterungs- bzw. temperaturabhängige Veränderungen des Offsetfehlers in einem Lebenszyklus der entsprechenden Korrekturschaltung bzw. des Signalwandlers nicht adäquat berücksichtigt werden könnten. Mit der vorliegenden Erfindung ist es dagegen vorteilhaft möglich, den Offsetfehler des Signalwandlers in regelmäßigen oder unregelmäßigen Abständen neu zu erfassen und den neu erfassten Offsetfehlerwert statt des zuvor verwendeten Offsetfehlerwerts zu verwenden.

Günstig ist es, wenn in einer Ausführungsform der Erfindung die Schritte a) bis e) wiederholt ausgeführt werden. Dies bietet den Vorteil, dass eine Anpassung des zur Korrektur der Messwerte verwendeten Offsetfehlerwerts an den aktuellen Offsetfehler des Signalwandlers möglich ist, so dass nicht auf einen bei der Herstellung des Signalwandlers oder der entsprechenden Korrekturvorrichtung einprogrammierten Offsetfehlerwert zurückgegriffen werden muss. Dieser werkseitig eingestellte Offsetfehlerwert könnte durch alterungs- oder temperaturabhängige Prozesse nicht mehr ausreichend exakt den aktuellen Offsetfehlerwert wiederspiegeln, so dass ein hochgenaues Messergebnis bei Einsatz des Signalwandlers nicht mehr erreicht werden könnte.

In einer weiteren Ausführungsform der Erfindung können die Schritte a) bis e) in Abhängigkeit von einem Alter oder einer Temperatur des Signalwandlers oder einer Schaltung zur Ausführung des Verfahrens ausgeführt werden. Hierbei kann beispielsweise durch die Erfassung eines bestimmten Alters oder einem Überschreiten der Temperatur einer Schaltung oder des Signalwandlers angenommen werden, dass möglicherweise eine Offset-Verschiebung stattgefunden hat, welche eine Neumessung des Offsetfehlers erforderlich macht. Auf diese Weise wird zur Korrektur des Offsetfehlers des Signalwandlers immer die Verwendung eines möglichst aktuellen Offsetfehlerwerts sichergestellt.

Weiterhin kann auch im Schritt b) der Offsetwert in einen Speicher geschrieben werden, wobei ein vor der Ausführung des Schritts b) in diesem Speicher gespeicherter Wert durch die Ausführung des Schritts b) überschrieben wird. Dies bietet den Vorteil, dass in jedem Fall ein Offsetfehlerwert zur Korrektur verwendet werden kann, auch wenn er nicht immer dem aktuellen Offsetfehler des Signalwandlers entspricht. Dabei wird von der Annahme ausgegangen, dass der im Speicher abgelegte Offsetfehlerkorrekturwert immer eine Offsetfehlerkorrektur ermöglicht, die ein besseres Messergebnis liefert, als wenn keine Offsetfehlerkorrektur durchgeführt würde.

Ferner kann in einer weiteren Ausführungsform der vorliegenden Erfindung im Schritt b) beim erstmaligen Ausführen des Verfahrens in einer Schaltungseinheit ein bei der Herstellung der Schaltungseinheit in den Speicher eingespeicherter Initialwert überschrieben werden. Hierdurch wird sichergestellt, dass zu Beginn des Betriebs des Signalwandlers auch ohne die Erfassung des Offsetfehlers ein Offsetfehlerkorrekturwert vorliegt, der zur Offsetfehlerkorrektur verwendet werden kann. Auf Grund der Tatsache, dass nach Herstellung von Schaltungskomponenten diese oftmals über einen längeren Zeitraum konstante Offseteigenschaften haben, kann aus Gründen der Vereinfachung und zur Sicherstellung einer hohen Genauigkeit der erhaltenen Messwerte werkseitig bereits ein erster Offsetfehlerkorrekturwert in dem Speicher abgelegt werden, ohne dass die später durchzuführende Anpassung dieses für die Offsetfehlerkorrektur verwendeten Offsetfehlerkorrekturwertes unmöglich gemacht oder behindert wird. Außerdem kann durch das Überschreiben des Speichers mit dem aktuellen Offsetfehlerkorrekturwert der erforderliche Speicherbedarf in der Recheneinheit reduziert werden.

Weiterhin können in einer anderen Ausführungsform der Erfindung die Schritte a) und c) unter Verwendung einer Steuereinheit ausgeführt werden, die einen Multiplexer zum Verbinden des Eingangs des Signalwandlers mit dem Offsetkanal und zum Kontaktieren des Eingangs des Signalwandlers mit der zu messenden elektrischen Größe ansteuert. Auf diese Weise können die entsprechenden Zuleitungen von Werten des Messkanals bzw. des Offsetkanals an den Eingang des Signalwandlers schaltungstechnisch einfach implementiert werden, ohne dass die Schaltungstopologie der Korrekturvorrichtung aufwändig geändert werden müsste. Die Ansteuerung durch die Steuereinheit lässt sich ebenfalls mit einfachen Mitteln implementieren.

Besonders günstig ist eine Ausführungsform der vorliegenden Erfindung, bei der in den Schritte a) und c) ein analoges Signal dem Eingang des Signalwandlers zugeführt wird und in den Schritten b) und d) ein digitales Signal am Ausgang des Signalwandlers abgegriffen wird. In einer solchen Ausführungsform der Erfindung kann eine Offsetfehlerkompensation bei Analog-Digital-Wandlern erfolgen, die eine besonders kritische Schwachstelle eines Signalverarbeitungspfades darstellen. Insbesondere durch die frühe Stellung von A/D-Wandlern im Signalverarbeitungspfad wirken sich Fehler, die bei der A/D-Wandlung auftreten besonders unvorteilhaft auf die nachfolgende Verarbeitung eines Messwertes aus. Nachdem jedoch eine digitale Verarbeitung eines Messsignals sowohl systemtechnische als auch implementationstechnische Vorteile aufweist, bietet die Offsetfehlerkorrektur bereits bei bzw. unmittelbar nach der A/D-Wandlung Vorteile für das zu implementierende Gesamtsystem.

Auch kann in einer weiteren Ausführungsform der Erfindung im Schritt a) der Eingang des Signalwandlers mit einem Masseanschluss verbunden werden, welcher als Offsetkanal verwendet wird. Auf diese Weise wird ein in der Schaltungsstruktur zur Ausführung des Verfahrens nahezu überall vorhandenes "Referenzpotential" in Form der "Masse" verwendet, um den Offsetfehler des Signalwandlers zu bestimmen. Weiterhin vereinfacht auch die Bestimmung des Massepotentials als Referenzspannungswert bzw. Referenzstromwert eine Bestimmung des korrigierten Messfehlers, da eine einfache Addition bzw. Subtraktion des Offsetfehlerwertes vom detektierten Messwert zum korrigierten Messwert führt.

### Kurze Beschreibung der Zeichnungen

Die Erfindung wird nachstehend anhand der beigefügten Figuren beispielhaft näher erläutert. Es zeigt:
- Fig. 1: ein schematisches Blockschaltbild eines Ausführungsbeispiels der vorliegenden Erfindung als Vorrichtung; und
- Fig. 2: ein Ablaufdiagramm eines Ausführungsbeispiels der vorliegenden Erfindung als Verfahren.

Eventuell angegebene Dimensionen und Maße sind nur exemplarisch, so dass die Erfindung nicht auf diese Dimensionen und Maße beschränkt ist. Gleiche oder ähnliche Elemente sind mit gleichen oder ähnlichen Bezugszeichen versehen. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden können oder sie zu weiteren, hier nicht explizit beschriebenen Kombinationen zusammengefasst werden können.

### Ausführungsformen der Erfindung

Das nachstehend an Hand der beigefügten Figuren vorgestellte Ausführungsbeispiel der Erfindung beschreibt ein Verfahren, den meist immer vorhandenen Offsetfehler beispielsweise eines AD-Wandlers, beziehungsweise der Messkette, automatisch zu kompensieren.

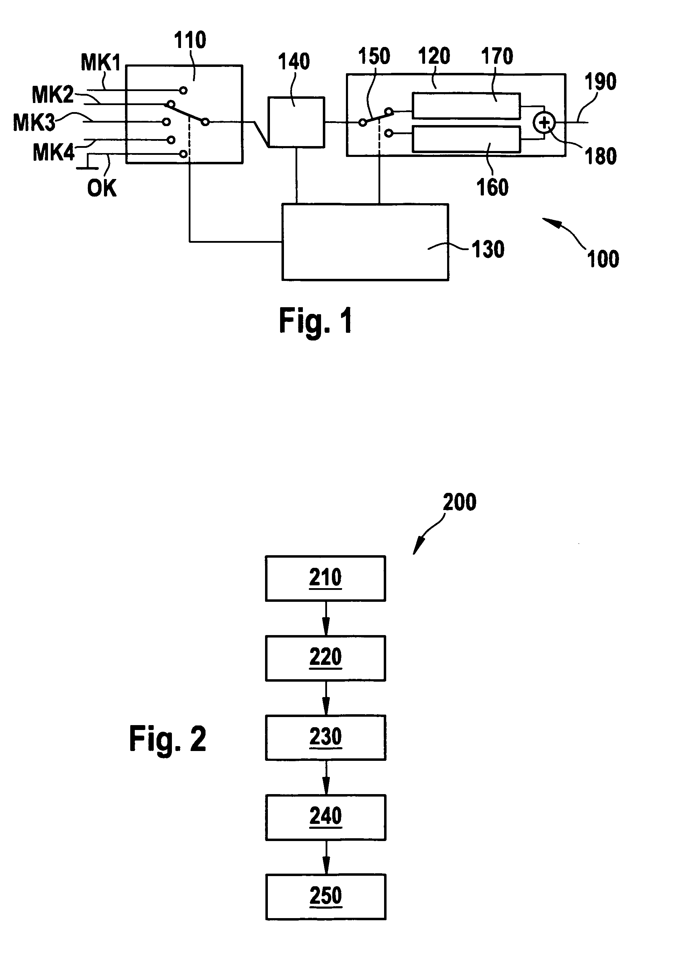

Hierzu kann eine Schaltungsstruktur verwendet werden, wie sie im Blockschaltbild aus Fig. 1 exemplarisch dargestellt ist. Das in Figur 1 dargestellte Ausführungsbeispiel einer Korrekturvorrichtung 100 umfasst einen Multiplexer 110, eine Recheneinheit 120 sowie eine Steuereinheit 130, wobei die Steuereinheit 130 mit dem Multiplexer, der Recheneinheit 120 und evtl. mit einem Signalwandler 140 verbunden ist. Der Multiplexer 110 ist ausgebildet, um ansprechend auf ein Signal der Steuereinheit 130 einen Eingang des Signalwandlers 140 (im vorliegenden Beispiel eines Analog-DigitalWandlers) entweder mit einem von vier Messkanälen MK1 - MK4 oder mit einem Offsetkanal OK zu verbinden. Der Offsetkanal OK wird durch einen Masseanschluss gebildet, der eine Referenzspannung von 0 V und/oder einen Referenzstrom von 0 A liefert. Weiterhin kann die Steuereinheit 130 ausgebildet sein, um ein Signal an eine Weiche 150 der Recheneinheit 120 auszugeben, die einen Ausgang des Signalwandlers 140 entweder mit einem Offsetfehlerwertspeicher 160 oder mit einem Messwertspeicher 170 verbindet. Der Offsetfehlerwertspeicher 160 und der Messwertspeicher 170 sind im vorliegenden Ausführungsbeispiel Einheiten der Recheneinheit 120. Weiterhin kann die Recheneinheit 120 ausgebildet sein, um eine Verknüpfung 180 der Werte des Offsetfehlerwertspeichers 160 und des Messwertspeichers 170 durchzuführen, die beispielsweise in einer Addition oder einer Subtraktion der genannten Werte miteinander bzw. voneinander besteht. Das Ergebnis dieser Verknüpfung 180 kann über den Datenbus 190 an weitere signalverarbeitende Einheiten übertragen werden, die jedoch in Fig. 1 nicht bildlich dargestellt sind.

Anzumerken ist in diesem Zusammenhang, dass der Signalwandler 140 nicht zwingend Element der Korrekturvorrichtung 100 sein muss; vielmehr kann die Korrekturvorrichtung 100 vor bzw. hinter einen beliebigen Signalwandler 140 geschaltet werden, so dass eine Offsetfehlerkorrektur von Ausgabewerten dieses Signalwandlers 140 möglich wird. Der Signalwander 140 kann alternativ jedoch auch Teil der Korrekturvorrichtung 100 sein.

Der Offsetfehler des Signalwandlers 140 kann zu jeder beliebigen Zeit gemessen werden und bleibt bis zur nächsten Messung als Korrekturwert in dem Offsetfehlerwertspeicher 160 der als (elektronischem) Auswerte-Baustein implementierten Recheneinheit 120 gespeichert. Jeder gemessene Messwert wird in dem Messwertspeicher 170 gespeichert bzw. automatisch mit dem Offsetfehlerkorrekturwert aus dem Offsetfehlerwertspeicher 160 verrechnet und der erhaltene korrigierte Messwert auf den Datenbus 190 übergeben. Die durch die Steuereinheit 130 freie programmierbare Wahl der Messzeitpunkte für die Erfassung des den Offsetfehlerkorrekturwerts erlaubt auch die Kompensation von dynamischen Fehlern, welche temperatur- oder alterungsabhängig sind.

Das in Fig. 1 dargestellte Ausführungsbeispiel der vorliegenden Erfindung zeichnet sich dadurch aus, dass einem A/D-Wandler 140 ein Multiplexer 110 vorgeschaltet ist, der die Möglichkeit bietet, über einen entsprechenden Offsetkanal OK eine "Nullmessung" bzw. eine Kalibrationsmessung durchzuführen. Das Ergebnis dieser Nullmessung, besteht in einem aktuellen Wert, den die in Fig. 1 dargestellte Messkette für 0 Volt Messspannung bzw. 0 mA Messstrom misst. Der Offsetkanal besteht dabei aus einem Anschlusskontakt für ein Massepotential, welches in der Schaltungsstruktur nahezu überall verfügbar ist. Dieser Offsetfehlerwert wird vom analogen Bereich durch den Signalwandler in eine digitale Variante überführt und über die entsprechen dem Offsetfehler-Messmodus der Korrekturvorrichtung 100 einem internen Register 160 der Recheneinheit 120 abgelegt. Dabei wird der vorherige Inhalt dieses internen Registers (d.h. des Offsetfehlerwertspeicher 160) überschrieben.

Soll nun eine Messung einer elektrischen Größe, wie beispielsweise einer Spannung oder eines Stromes, erfolgen, wird durch die Steuereinheit 130 in einen zweiten Betriebsmodus der Korrekturvorrichtung 100 geschaltet, in der ein Signal an den Multiplexer 110 ausgegeben wird, um den Eingang des Signalwandlers 140 mit einem der Messkanäle MK1 bis MK4 zu verbinden. Zugleich wird durch die Steuereinheit im zweiten Betriebsmodus ein Signal an die Weiche 150 ausgegeben, um den Ausgang des Signalwandlers 140 mit dem Messwertspeicher 170 zu verbinden. Der vom Ausgang des Signalwandlers 140 empfangene Messwert wird folglich im Messwertspeicher 170 abgespeichert und nachfolgend mit dem Wert aus dem Offsetfehlerspeicher 160 verknüpft (beispielsweise durch Addition mit dem Wert des Offsetfehlerspeichers bzw. Subtraktion von dem Wert des Offsetfehlerspeichers). Diese Verknüpfung kann durch ein hardwaretechnisch realisiertes Element 180 (beispielsweise in einer anwenderspezifischen integrierten Schaltung oder einem fest verdrahteten Addierer bzw. Subtrahierer) erfolgen, welches eine deutlich schnellere Ausführung der Offsetfehlerkorrektur ermöglicht, als eine Software-basierte Verknüpfung des Messwertes aus dem Messwertspeicher 170 mit dem Offsetfehlerwert aus dem Offsetwertspeicher 160. Zugleich müsste eine solche Software-basierte Auswertung zunächst ein Kommunikationssignal zur Umschaltung der Messung auf die Erfassung des Offsets durchführen, was einen erhöhten Signalisierungsaufwand bei der Datenübertragung über den Datenbus 190 erfordert.

Solange keine erste Nullmessung der Korrekturvorrichtung 100 aktiviert wurde, ist in dem internen Register 160 ein Offsetfehler-Korrekturwert gespeichert, der anhand der Schaltungsauslegung standardmäßig erwartet wird und der werkseitig bereits in das interne Register 160 gespeichert wurde. Dieses Vorgehen stellt sicher, dass in jedem Fall eine Offsetfehlerkorrektur des gemessenen Messwertes erfolgt, auch wenn der aktuelle Offsetwert des Signalwandlers 140 noch nicht bekannt ist. Diesem Ansatz liegt die Idee zugrunde, dass ein mit einem nicht aktuellen Offsetfehlerwert korrigierter Messwert immer noch genauer ist als ein nicht korrigierter Messwert. Somit kann sichergestellt werden, dass immer eine Mindestgenauigkeit des korrigierten Messwertes gegeben ist.

Jeder Messwert eines Messkanals wird immer mit dem Inhalt dieses internen Registers (d.h. des Offsetwertspeichers 160) verrechnet und der korrigiert Messwert wird über den Datenbus 190 an einen in Fig. 1 nicht dargestellten Prozessor geliefert. Da die Offsetmessung beliebig oft und zu jedem Zeitpunkt durchgeführt werden kann, ist es möglich Auswirkungen von nahezu allen Einflüssen zu kompensieren, die sich während eines Betriebszyklus ergeben.

In Fig. 2 ist Ablaufdiagramm eines weiteren Ausführungsbeispiels der vorliegenden Erfindung dargestellt, die als Verfahren ausgestaltet ist. Das Verfahren 200 entspricht dabei einem Zyklus einer Offsetfehlermessung mit der Speicherung des gemessenen Offsetfehlers des Signalwandlers 140 und nachfolgender Korrektur des Messwertes mit diesem Offsetfehlerwert. Das in Fig. 2 dargestellte Verfahren 200 umfasst einen ersten Schritt des Verbindens 210 eines Eingangs des Signalwandlers 140 mit einem Offsetkanal OK, der ausgebildet ist, um einen vordefinierten Referenzspannungswert oder einen vordefinierten Referenzstromwert bereitzustellen. In einem zweiten Schritt erfolgt ein Erfassen 220 und Speichern eines an einem Ausgang des Signalwandlers 140 bereitgestellten Offsetwertes, den der Signalwandler 140 ansprechend auf die Beaufschlagung mit dem vordefinierten Referenzspannungswert oder Referenzstromwert liefert. Hierauf folgend umfasst das Verfahren 200 in einem dritten Schritt ein Kontaktieren 230 des Eingangs des Signalwandlers 140 mit einer zu messenden elektrischen Größe, die an zumindest einem Messkanal anliegt. Nach dem dritten Schritt des Kontaktierens 230 wird in dem Verfahren 200 ein vierter Schritt ausgeführt, nämlich ein Detektieren 240 eines an dem Ausgang des Signalwandlers 140 bereitgestellten Messwertes, den der Signalwandler 140 ansprechend auf die Beaufschlagung mit der elektrischen Größe liefert. Der detektierte Messwert wird in einem fünften Schritt 250 mit dem Offsetwert auf der Basis einer Verknüpfungsstruktur in Hardware verknüpft, um einen korrigierten Messwert zu erhalten und diesen korrigierten Messwert für eine Übertragung in eine weitere Datenverarbeitungseinheit bereitzustellen.

## Patentansprüche

1. Verfahren (200) zur Korrektur eines Offsetfehlers eines Signalwandlers (140), wobei das Verfahren (200) die folgenden Schritte aufweist:
a) Verbinden (210) eines Eingangs des Signalwandlers (140) mit einem Offsetkanal (OK), der ausgebildet ist, um einen vordefinierten Referenzspannungswert oder einen vordefinierten Referenzstromwert bereitzustellen;
b) Erfassen (220) und Speichern eines an einem Ausgang des Signalwandlers (140) bereitgestellten Offsetwertes, den der Signalwandler (140) ansprechend auf die Beaufschlagung mit dem vordefinierten Referenzspannungswert oder Referenzstromwert liefert, wobei das Speichern des Offsetwertes in einen Offsetfehlerwertspeicher (160) erfolgt;
c) Kontaktieren (230) des Eingangs des Signalwandlers (140) mit einer zu messenden elektrischen Größe, die an zumindest einem Messkanal (MK1 - MK4) anliegt;
d) Detektieren (240) eines an dem Ausgang des Signalwandlers (140) bereitgestellten Messwertes, den der Signalwandler (140) ansprechend auf die Beaufschlagung mit der elektrischen Größe liefert und Speichern des Messwertes in einem Messwertspeicher (170); und
**gekennzeichnet, durch** einen Schritt des
e) Verknüpfens (250) des Messwertes aus dem Messwertspeicher (170) mit dem Offsetwert aus dem Offsetfehlerwertspeicher (160) auf der Basis einer Verknüpfungsstruktur(180) in Hardware, um einen korrigierten Messwert zu erhalten und diesen korrigierten Messwert für eine Übertragung (190) in eine weitere Datenverarbeitungseinheit bereitzustellen, wobei
ein Signal einer Steuereinheit (130) an eine Weiche (150) ausgegeben wird, wobei die Weiche (150) ausgebildet ist, um den Ausgang des Signalwandlers (140) ansprechend auf das Signal der Steuereinheit (130) entweder mit dem Offsetfehlerwertspeicher (160) oder mit dem Messwertspeicher (170) zu verbinden.

2. Verfahren (200) gemäß Anspruch 1, **dadurch gekennzeichnet, dass** die Schritte a) (210) bis e) (250) wiederholt ausgeführt werden.

3. Verfahren (200) gemäß Anspruch 1 oder 2, **dadurch gekennzeichnet, dass** die Schritte a) (210) bis e) (250) in Abhängigkeit von einem Alter oder der Temperatur des Signalwandlers (140) oder einer Korrekturvorrichtung (100) zur Ausführung des Verfahrens (200) ausgeführt werden.

4. Verfahren (200) gemäß einem der Ansprüche 1 bis 3, **dadurch gekennzeichnet, dass** bei einer Ausführung des Schritts b) (220) der Offsetwert in den Offsetfehlerwertspeicher (160) geschrieben wird, wobei ein vor der Ausführung des Schritts b) (220) in diesem Offsetfehlerwertspeicher (160) gespeicherter Wert durch die Ausführung des Schritts b) (220) überschrieben wird.

5. Verfahren (200) gemäß Anspruch 4, **dadurch gekennzeichnet, dass** bei der Ausführung des Schritts b) (220) beim erstmaligen Ausführen des Verfahrens (200) in einer Korrekturvorrichtung (100) ein bei der Herstellung der Korrekturvorrichtung (100) in den Offsetfehlerwertspeicher (160) eingespeicherter Initialwert überschrieben wird.

6. Verfahren (200) gemäß einem der Ansprüche 1 bis 5, **dadurch gekennzeichnet, dass** die Schritte a) (210) und c) (230) unter Verwendung einer Steuereinheit (130) ausgeführt werden, die einen Multiplexer (110) zum Verbinden des Eingangs des Signalwandlers (140) mit dem Offsetkanal (OK) und zum Kontaktieren des Eingangs des Signalwandlers (140) mit der zu messenden elektrischen Größe ansteuert.

7. Verfahren (200) gemäß einem der Ansprüche 1 bis 6, **dadurch gekennzeichnet, dass** in den Schritte a) (210) und c) (230) ein analoges Signal dem Eingang des Signalwandlers (140) zugeführt wird und in den Schritten b) (220) und d) (240) ein digitales Signal am Ausgang des Signalwandlers (140) abgegriffen wird.

8. Verfahren (200) gemäß einem der Ansprüche 1 bis 7, **dadurch gekennzeichnet, dass** im Schritt a) (210) der Eingang des Signalwandlers (140) mit einem Masseanschluss verbunden wird, welcher als Offsetkanal (OK) verwendet wird.

9. Korrekturvorrichtung (100) zur Korrektur eines Offsetfehlers eines Signalwandlers (140), wobei die Korrekturvorrichtung (100) folgende Merkmale umfasst:
- einen Multiplexer (110) zum Verbinden eines Eingangs eines Signalwandlers (140) mit zumindest einem Messkanal (MK1-MK4) oder mit einem Offsetkanal (OK), wobei der Offsetkanal (OK) ausgebildet ist, um eine vordefinierte Referenzspannung oder einen vordefinierten Referenzstrom bereitzustellen;
- eine Recheneinheit (120), die ausgebildet ist, um einen von einem Ausgang des Signalwandlers (140) bereitgestellten Wert als Offsetwert in einen Offsetfehlerwertspeicher (160) zu speichern oder einen vom Ausgang des Signalwandlers (140) bereitgestellten Wert als Messwert in einem Messwertspeicher (170) zu speichern und den in dem Messwertspeicher (170) gespeicherten Messwert mit dem im Offsetfehlerwertspeicher (160) gespeicherten Offsetwert auf der Basis einer Verknüpfungsstruktur (180) in Hardware zu verknüpfen und den erhaltenen Wert als korrigierten Messwert einer Übertragungseinheit (190) bereitzustellen,; und
- eine Steuereinheit (130), die ausgebildet ist, um den Multiplexer (110) und die Recheneinheit (120) in einen ersten oder zweiten Betriebsmodus zu schalten,
**dadurch gekennzeichnet, dass**
die Recheneinheit (120) eine Weiche (150) aufweist, die ausgebildet ist, um den Ausgang des Signalwandlers (140) ansprechend auf ein Signal der Steuereinheit (130) entweder mit dem Offsetfehlerwertspeicher (160) oder mit dem Messwertspeicher (170) zu verbinden und wobei im ersten Betriebsmodus der Eingang des Signalwandlers (140) mit dem Offsetkanal (OK) verbunden ist und der vom Ausgang des Signalwandlers (140) bereitgestellte Wert in der Recheneinheit (120) als Offsetfehlerwert interpretiert wird und im zweiten Betriebsmodus der Eingang des Signalwandlers (140) mit einem Messkanal (MK1 - MK4) verbunden wird und der vom Ausgang des Signalwandlers (140) bereitgestellte Wert in der Recheneinheit (120) als Messwert interpretiert wird.

## Claims

1. Method (200) for correcting an offset error of a signal converter (140), the method (200) having the following steps of:
a) connecting (210) an input of the signal converter (140) to an offset channel (OK) which is designed to provide a predefined reference voltage value or a predefined reference current value;
b) recording (220) and storing an offset value which is provided at an output of the signal converter (140) and is provided by the signal converter (140) in response to the application of the predefined reference voltage value or reference current value, the offset value being stored in an offset error value memory (160);
c) making contact (230) with the input of the signal converter (140) using an electrical variable which is to be measured and is applied to at least one measuring channel (MK1 - MK4);
d) detecting (240) a measured value which is provided at the output of the signal converter (140) and is provided by the signal converter (140) in response to the application of the electrical variable, and storing the measured value in a measured value memory (170); and
**characterized by a step of**
e) linking (250) the measured value from the measured value memory (170) to the offset value from the offset error value memory (160) on the basis of a linking structure (180) in hardware in order to obtain a corrected measured value and to provide this corrected measured value for transmission (190) to a further data processing unit,
a signal from a control unit (130) being output to a switch (150), the switch (150) being designed to connect the output of the signal converter (140) either to the offset error value memory (160) or to the measured value memory (170) in response to the signal from the control unit (130).

2. Method (200) according to Claim 1, **characterized in that** steps a) (210) to e) (250) are carried out repeatedly.

3. Method (200) according to Claim 1 or 2, **characterized in that** steps a) (210) to e) (250) are carried out on the basis of an age or the temperature of the signal converter (140) or a correction apparatus (100) for carrying out the method (200).

4. Method (200) according to one of Claims 1 to 3, **characterized in that** the offset value is written to the offset error value memory (160) when carrying out step b) (220), a value stored in this offset error value memory (160) before carrying out step b) (220) being overwritten by carrying out step b) (220).

5. Method (200) according to Claim 4, **characterized in that** an initial value stored in the offset error value memory (160) when producing the correction apparatus (100) is overwritten when carrying out step b) (220) when carrying out the method (200) for the first time.

6. Method (200) according to one of Claims 1 to 5, **characterized in that** steps a) (210) and c) (230) are carried out using a control unit (130) which controls a multiplexer (110) for connecting the input of the signal converter (140) to the offset channel (OK) and for making contact with the input of the signal converter (140) using the electrical variable to be measured.

7. Method (200) according to one of Claims 1 to 6, **characterized in that** an analogue signal is supplied to the input of the signal converter (140) in steps a) (210) and c) (230) and a digital signal is tapped off at the output of the signal converter (140) in steps b) (220) and d) (240).

8. Method (200) according to one of Claims 1 to 7, **characterized in that**, in step a) (210), the input of the signal converter (140) is connected to an earth connection which is used as the offset channel (OK).

9. Correction apparatus (100) for correcting an offset error of a signal converter (140), the correction apparatus (100) comprising the following features:
- a multiplexer (110) for connecting an input of a signal converter (140) to at least one measuring channel (MK1 - MK4) or to an offset channel (OK), the offset channel (OK) being designed to provide a predefined reference voltage or a predefined reference current;
- a computation unit (120) which is designed to store a value provided by an output of the signal converter (140) as an offset value in an offset error value memory (160) or to store a value provided by the output of the signal converter (140) as a measured value in a measured value memory (170) and to link the measured value stored in the measured value memory (170) to the offset value stored in the offset error value memory (160) on the basis of a linking structure (180) in hardware and to provide a transmission unit (190) with the value obtained as the corrected measured value; and
- a control unit (130) which is designed to switch the multiplexer (110) and the computation unit (120) to a first or a second operating mode,
**characterized in that**
the computation unit (120) has a switch (150) which is designed to connect the output of the signal converter (140) either to the offset error value memory (160) or to the measured value memory (170) in response to a signal from the control unit (130), the input of the signal converter (140) being connected to the offset channel (OK) and the value provided by the output of the signal converter (140) being interpreted as an offset error value in the computation unit (120) in the first operating mode, and the input of the signal converter (140) being connected to a measuring channel (MK1 - MK4) and the value provided by the output of the signal converter (140) being interpreted as a measured value in the computation unit (120) in the second operating mode.

## Revendications

1. Procédé (200) de correction d'une erreur de polarisation d'un convertisseur (140) de signaux, le procédé (200) comportant les étapes suivantes :
a) raccordement (210) d'une entrée du convertisseur (140) de signaux à un canal de polarisation (OK) configuré pour délivrer une valeur prédéfinie de tension de référence ou une valeur prédéfinie de courant de référence,
b) saisie (220) et mise en mémoire d'une valeur de polarisation délivrée à une sortie du convertisseur (140) de signaux et que le convertisseur (140) de signaux délivre lorsque la valeur prédéfinie de tension de référence ou la valeur prédéfinie de courant de référence lui sont appliquées, la mise en mémoire de la valeur de polarisation s'effectuant dans une mémoire (160) à valeurs d'erreur de polarisation,
c) mise en contact (230) de l'entrée du convertisseur (140) de signaux avec une grandeur électrique à mesurer qui est appliquée sur au moins un canal de mesure (MK1 - MK4),
d) détection (240) d'une valeur de mesure délivrée à la sortie du convertisseur (140) de signaux et que le convertisseur (140) de signaux délivre en réponse à l'application de la grandeur électrique, et mise en mémoire de la valeur de mesure dans une mémoire (170) de valeurs de mesure,
**caractérisé par** une étape de
e) association (250) de la valeur de mesure provenant de la mémoire (170) de valeurs de mesure et de la valeur de polarisation provenant de la mémoire (160) de valeurs d'erreur de polarisation sur la base d'une structure d'association (180) réalisée physiquement, pour obtenir une valeur de mesure corrigée et délivrer cette valeur de mesure corrigée en vue de la transférer (190) dans une autre unité de traitement de données,
un signal d'une unité de commande (130) étant délivré à un aiguillage (150), l'aiguillage (150) étant configuré pour relier la sortie du convertisseur (140) de signaux soit à la mémoire (160) de valeurs d'erreur de polarisation soit à la mémoire (170) de valeurs de mesure en réponse au signal de l'unité de commande (130).

2. Procédé (200) selon la revendication 1, **caractérisé en ce que** les étapes a) (210) à e) (250) sont exécutées de manière répétée.

3. Procédé (200) selon les revendications 1 ou 2, **caractérisé en ce que** les étapes a) (210) à e) (250) sont exécutées en fonction de l'âge ou de la température du convertisseur (140) de signaux ou d'un dispositif de correction (100) servant à exécuter le procédé (200).

4. Procédé (200) selon l'une des revendications 1 à 3, **caractérisé en ce que** lors de l'exécution de l'étape b) (220), la valeur de polarisation est écrite dans la mémoire (160) de valeurs d'erreur de polarisation, une valeur conservée dans cette mémoire (160) de valeurs d'erreur de polarisation avant l'exécution de l'étape b) (220) étant écrasée par l'exécution de l'étape b) (220).

5. Procédé (200) selon la revendication 4, **caractérisé en ce que** lors de l'exécution de l'étape b) (220) lors de la première exécution du procédé (200) dans un dispositif de correction (100), une valeur initiale conservée en mémoire dans la mémoire (160) de valeurs d'erreur de polarisation lors de la fabrication du dispositif de correction (100) est écrasée.

6. Procédé (200) selon l'une des revendications 1 à 5, **caractérisé en ce que** les étapes a) (210) et c) (230) sont exécutées en recourant à une unité de commande (130) qui commande un multiplexeur (110) qui sert à relier l'entrée du convertisseur (140) de signaux au canal de polarisation (OK) et à mettre en contact l'entrée du convertisseur (140) de signaux avec la grandeur électrique à mesurer.

7. Procédé (200) selon l'une des revendications 1 à 6, **caractérisé en ce qu'**au cours des étapes a) (210) et c) (230), un signal analogique est apporté à l'entrée du convertisseur (140) de signaux et **en ce que** lors des étapes b) (220) et d) (240), un signal numérique est prélevé à la sortie du convertisseur (140) de signaux.

8. Procédé (200) selon l'une des revendications 1 à 7, **caractérisé en ce que** lors de l'étape a) (210), l'entrée du convertisseur (140) de signaux est raccordée à une borne de masse utilisée comme canal de polarisation (OK).

9. Dispositif de correction (100) destiné à corriger l'erreur de polarisation d'un convertisseur (140) de signaux, le dispositif de correction (100) présentant les caractéristiques suivantes :
un multiplexeur (110) reliant une entrée d'un convertisseur (140) de signaux à au moins un canal de mesure (MK1 - MK4) ou à un canal de polarisation (OK), le canal de polarisation (OK) étant configuré pour délivrer une tension de référence prédéfinie ou un courant de référence prédéfini,
une unité de calcul (120) configurée pour conserver en tant que valeur de polarisation dans une mémoire (160) de valeurs d'erreur de polarisation une valeur délivrée à une sortie du convertisseur (140) de signaux ou de conserver en tant que valeur de mesure dans une mémoire (170) de valeurs de mesure une valeur délivrée à la sortie du convertisseur (140) de signaux, pour associer la valeur de mesure conservée dans la mémoire (170) de valeurs de mesure à la valeur de polarisation conservée dans la mémoire (160) de valeurs d'erreur de polarisation sur la base d'une structure d'association (180) réalisée physiquement et pour délivrer la valeur obtenue à une unité de transfert (190) en tant que valeur de mesure corrigée et
une unité de commande (130) configurée pour commuter le multiplexeur (110) et l'unité de calcul (120) entre un premier et un deuxième mode de fonctionnement,
**caractérisé en ce que**
l'unité de calcul (120) présente un aiguillage (150) configuré pour relier la sortie du convertisseur (140) de signaux soit à la mémoire (160) de valeurs d'erreur de polarisation soit à la mémoire (170) de valeurs de mesure en réponse à un signal de l'unité de commande (130),
**en ce que** dans le premier mode de fonctionnement, l'entrée du convertisseur (140) de signaux est reliée au canal de polarisation (OK) et la valeur délivrée à la sortie du convertisseur (140) de signaux est interprétée dans l'unité de calcul (120) comme valeur d'erreur de polarisation et dans le deuxième mode de fonctionnement, l'entrée du convertisseur (140) de signaux est reliée à un canal de mesure (MK1 - MK4), la valeur délivrée à la sortie du convertisseur (140) de signaux étant interprétée en tant que valeur de mesure dans l'unité de calcul (120).
